# EUROPÄISCHE PATENTSCHRIFT

(11) **EP 4 184 592 B1**
(45) Veröffentlichungstag und Bekanntmachung des Hinweises auf die Patenterteilung: **01.01.2025**
(21) Anmeldenummer: 21208784.5
(22) Anmeldetag: 17.11.2021
(51) Int. Cl.: H01L 31/048, H02S 20/22, E04F 13/14, H02S 20/23, F24S 20/66, H02S 20/26, B32B 27/40, B32B 27/32, B32B 27/30, B32B 27/28, B32B 21/08, B32B 17/10, B32B 9/04, B32B 9/00, E04F 13/08, F24S 20/67

(54) **BESCHICHTETES MODUL EINER SOLARANLAGE**
COATED SOLAR SYSTEM MODULE
MODULE REVÊTU D'UNE INSTALLATION SOLAIRE

(43) Veröffentlichungstag der Anmeldung: 24.05.2023
(73) Patentinhaber: Schiefergruben Magog GmbH & Co. KG, 57392 Schmallenberg (DE)
(72) Erfinder: GUNTERMANN, Georg, 57392 Schmallenberg (DE)
(74) Vertreter: Michalski Hüttermann & Partner Patentanwälte mbB

(56) Entgegenhaltungen:
- EP-A1- 3 785 900
- WO-A1-2020/155628
- DE-A1- 102011 078 690
- DE-U1- 202020 004 239

## Beschreibung

Die Erfindung betrifft ein beschichtetes Modul einer Solaranlage, ein Verfahren zu dessen Herstellung sowie dessen Verwendung.

Module einer Solaranlage an Gebäudefassaden oder auf Dächern sind nicht sehr hübsch. Es besteht der Bedarf, diese Zellen ästhetisch schöner zu gestalten. Bisher gab es das Vorurteil, dass eine Beschichtung mit dekorativen Materialien den Wirkungsgrad zu sehr beschränken würde.

Schiefer ist ein Steinmaterial, das gerne in der Dachdeckung aber auch als Oberfläche in Wohnräumen (z.B. Fußboden, Wand, Decke, Tischplatte, ...) eingesetzt wird. Ein wesentlicher Nachteil ist sein Gewicht. Weiterhin ist es nicht einfach, möglichst gleichartige große Schieferplatten für diese Einsatzzwecke im Schieferbergbau zu gewinnen.

Bisher gibt es nur sehr wenige Lösungsansätze, um Schiefer oder auch andere Steinarten in einem Produkt möglichst dünn und damit leicht und besser verarbeitbar bereitzustellen.

DE202020004239U1 beschreibt ein beschichtetes Photovoltaikmodul. Diese dort beschriebenen Beschichtungen können eine sehr unregelmäßige Schichtdicke und damit auch sehr unterschiedliche Lichttransmission aufweisen. Dadurch kann eine sehr unterschiedliche Auslastung der darunterliegenden Strings der Photovoltaikmodule entstehen, die dann wiederum zu einer erheblichen Brandgefahr führt. Die Erfinder dieses beschichteten Photovoltaikmoduls konnten Wirkungsgrade bis zu 10% nachweisen (beispielsweise in "Facade BIPV modules designed with stone veneers", pv magazine, 10. August 2021). Die Beschichtungen hatten dabei eine Dicke von etwa 1,5 mm. Typische unbeschichtete Photovoltaikmodule haben einen Wirkungsgrad von etwa 20%. WO 2020155628 A1 beschreibt ein Modul einer Solaranlage mit einer lichtdurchlässigen Steinschicht.

DE202006019074U1, DE102011078690A1 und JP11336293A beschreiben Schiefer auf Polymersubstraten. Keines dieser Produkte konnte sich bisher am Markt durchsetzen.

EP 3 920 241 A1 beschreibt ein energieerzeugendes Baumaterial und das Herstellungsverfahren.

EP 3 785 900 A1 beschreibt ein Dünnsteinerzeugnis.

Die Aufgabe der vorliegenden Erfindung besteht darin, eine Technologie bereitzustellen, um ein Modul einer Solaranlage mit Stein zu beschichten.

Diese Aufgabe wird in einer ersten Ausführungsform durch ein Modul einer Solaranlage gemäß Anspruch 1 gelöst, das mit einem lichtdurchlässigen Dünnsteinerzeugnis verklebt ist, wobei das Dünnsteinerzeugnis eine außenliegende Steinschicht, die eine Dicke im Median in einem Bereich von 0,6 bis 80 µm aufweist, und eine daran angrenzende Polymerschicht aufweist, wobei die Steinschicht eine Schieferschicht ist und der Winkel zwischen Schieferung und Schichtung in einem Bereich von 2 bis 90° liegt, wobei die Rauheit Ra der Oberfläche der Rückseite des Dünnsteinerzeugnisses in einem Bereich von 2 bis 100 µm gemessen nach DIN EN ISO 25178 liegt, wobei die Rückseite des Dünnsteinerzeugnisses die angrenzende Polymerschicht aufweist, und wobei das Dünnsteinerzeugnis auf der der Steinschicht gegenüberliegenden Seite eine Klebeschicht zum Verkleben mit dem Modul einer Solaranlage aufweist.

Der Vorteil dieses Molduls ist u.a. dass so auch Auflagen des Denkmalschutzes erfüllt werden können, da so Fassaden und Dächer mit einem natürlichen Material verkleidet werden können.

Die Rautiefe Rz der Oberfläche der Steinschicht liegt vorzugsweise in einem Bereich von 1 bis 200 µm.

Die Rautiefe kann beispielsweise gemäß DIN EN ISO 4287 gemessen werden. Die Rautiefe kann beispielsweise mit einem 3D Profilometer (z.B. 3D-Profilometer VR-5000 der Firma Keyence) gemessen werden. Eine definierte Messstrecke auf der Oberfläche des Werkstücks wird beispielsweise in sieben Einzelmessstrecken eingeteilt, wobei die mittleren fünf Messstrecken gleich groß sind. Die Auswertung erfolgt beispielsweise nur über diese fünf Messstrecken, da der anzuwendende Gauß-Filter eine halbe Einzelmessstrecke Vor- bzw. Nachlauf benötigt beziehungsweise eine Faltung ein nicht zu vernachlässigendes Ein- und Auslaufverhalten aufweist. Von jeder dieser Einzelmessstrecken des Profils wird beispielsweise die Differenz aus maximalem und minimalem Wert ermittelt. Aus den somit erhaltenen fünf Einzelrautiefen wird beispielsweise der Mittelwert der Rautiefe Rz gebildet.

Es hat sich herausgestellt, dass bei der Herstellung des Dünnsteinerzeugnisses die Polymerschicht oder auch die Steinschicht beim Abziehen von der Steinoberfläche abreißen oder einreißen kann, wenn die Rautiefe Rz größer als der bevorzugte Bereich ist. Dies führt dann zu Ausschuss in der Produktion und muss vermieden werden. Gerade bei Schiefer kommt es häufig vor, dass einzelne kleine Bereiche der Oberfläche starke Abweichungen von weit über 2 mm von der mittleren Oberfläche haben können. Werden diese Bereiche vor der Herstellung des erfindungsgemäßen Dünnsteinerzeugnisses nicht eingeebnet, so kann es an diesen Stellen leicht zu Fehlern durch Abriss der Polymer- oder der Steinschicht kommen. Diesem Problem haben sich die Erfinder erstmals angenommen.

Andererseits gibt es beispielsweise auch poliertes Gestein (wie beispielsweise Schiefer), der typischerweise eine Rautiefe Rz von < 20 µm aufweist. Diese Steinoberfläche kann unerwünscht sein, da der optische Eindruck von Naturstein wie beispielsweise Naturschiefer erzeugt werden soll.

Das resultierende erfindungsgemäße Dünnsteinerzeugnis hat also vorzugsweise eine Rautiefe der Oberfläche der Steinschicht Rz in einem Bereich von 1 bis 200 µm. Besonders bevorzugt liegt diese Rautiefe Rz in einem Bereich von 2 bis 150 µm.

Die Rauheit Ra der Oberfläche der Steinschicht liegt in einem Bereich von 2 bis 100 µm, besonders bevorzugt in einem Bereich von 5 bis 80 µm, gemessen nach DIN EN ISO 25178. Die Rauheit kann beispielsweise mit einem 3D Profilometer (z.B. 3D-Profilometer VR-5000 der Firma Keyence) gemessen werden.

### Modul einer Solaranlage

Das erfindungsgemäße Modul einer Solaranlage kann beispielsweise ein Photovoltaikmodul oder ein Sonnenkollektor (also Solarthermie) sein.

Die Länge des Photovoltaikmoduls liegt vorzugsweise in einem Bereich von 300 bis 2500 mm. Die Breite des Photovoltaikmoduls liegt vorzugsweise in einem Bereich von 200 bis 1500 mm. Die Dicke des Photovoltaikmoduls liegt vorzugsweise in einem Bereich von 0,5 bis 20 mm.

Die Photovoltaikmodul kann von einem der folgenden Typen sein: Glas-Glas-Modul, Glas-Folie-Modul, Folie-Glas-Modul, Folie-Folie-Modul. Vorzugsweise ist das Photovoltaikmodul ein sog. Glas-Glas-Modul.

### Dünnsteinerzeugnis

Vorzugsweise weist das Dünnsteinerzeugnis im Median eine Dicke in einem Bereich von 0,08 bis 3 mm, besonders bevorzugt im Median in einem Bereich von 0,4 bis 0,8 mm auf. Die Dicke ist über das Dünnsteinerzeugnis möglichst gleichbleibend, um das Dünnsteinerzeugnis besser verarbeiten und lagern zu können. Daher liegt die Standardabweichung der Dicke des Dünnsteinerzeugnisses vorzugsweise in einem Bereich von 0,005 bis 0,2 mm, besonders bevorzugt in einem Bereich von 0,05 bis 0,15 mm.

Vorzugsweise ist das Dünnsteinerzeugnis rollbar. Vorzugsweise liegt der Mindestbiegeradius des Dünnsteinerzeugnisses in einem Bereich von 1 bis 200 mm, ganz besonders bevorzugt in einem Bereich von 3 bis 50 mm. Dadurch lässt sich das Dünnsteinerzeugnis auch für gebogene und dreidimensionale Erzeugnisse/Anwendungen einsetzten und besonders leicht verpacken und transportieren. Der Mindestbiegeradius im Sinne der Erfindung ist definiert als der minimale Biegeradius, der beim Rollen des Dünnsteinerzeugnisses erzielt werden kann, ohne dass das Produkt Schaden nimmt (wie z.B. Abplatzungen oder Risse).

Auch ist das Dünnsteinerzeugnis lichtdurchlässig. Das Dünnsteinerzeugnis kann für bestimmte Anwendungen wie beispielsweise im Automobilbereich oder auch im Bereich der Beleuchtung lichtdurchlässig, insbesondere transluzent, sein. Die Transmission (für Licht) des Dünnsteinerzeugnisses liegt vorzugsweise in einem Bereich von 60 bis 99,9%, besonders bevorzugt 70 bis 90%. Die Transmission kann beispielsweise gemäß ISO 13468 (Lichtart D 65) gemessen werden.

Das Flächengewicht des Dünnsteinerzeugnisses liegt vorzugsweise in einem Bereich von 0,1 bis 1,7 kg/m2, ganz besonders bevorzugt in einem Bereich von 0,1 bis 0,6 kg/m2. Bisherige Erzeugnisse waren in der Regel wesentlich schwerer und damit beispielsweise aufwändiger zu verarbeiten und zu transportieren.

Die Rückseite des Dünnsteinerzeugnisses ist vorzugsweise glatt. Die Rückseite des Dünnsteinerzeugnisses weist auf ihrer Oberfläche ein Polymer auf. Die Rückseite des Dünnsteinerzeugnisses weist auf ihrer Oberfläche vorzugsweise keine Fasern (beispielsweise Gelege, Gewebe oder Vlies) auf. Die Rückseite kann auch sehr glatt sein. Die Rückseite kann geschliffen sein.

Die Rauheit Ra der Oberfläche der Rückseite des Dünnsteinerzeugnisses liegt in einem Bereich von 2 bis 100 µm, besonders bevorzugt in einem Bereich von 5 bis 50 µm gemessen nach DIN EN ISO 25178.

Die Rauheit kann beispielsweise mit einem 3D Profilometer (z.B. 3D-Profilometer VR-5000 der Firma Keyence) gemessen werden.

Die Oberflächenspannung der Oberfläche der Rückseite des Dünnsteinerzeugnisses liegt vorzugsweise in einem Bereich von 10 bis 40 mN/m, ganz besonders bevorzugt in einem Bereich von 20 bis 30 mN/m. Dadurch kann besonders gut eine gute Verklebbarkeit des Dünnsteinerzeugnisses erzielt werden. Die Oberflächenspannung kann beispielsweise mit Testtinte ermittelt werden.

Vorzugsweise liegt die Fläche der Steinschicht auf der Vorderseite des Dünnsteinerzeugnisses in einem Bereich von 0,2 bis 6 m², ganz besonders bevorzugt in einem Bereich von 1 bis 3,5 m². Dadurch können beispielsweise auch größere Fassaden ohne großen Aufwand mit Stein wie beispielsweise Schiefer verkleidet werden.

Vorzugsweise ist das Dünnsteinerzeugnis frostsicher. Dadurch sind auch Außenanwendungen möglich.

Die Polymerschicht umfasst vorzugsweise wenigstens 40 Gew.% Füllstoffe, die bei Erhitzen Wasser abgeben (wie beispielsweise Perlit).

Das Dünnsteinerzeugnis weist auf der der Steinschicht gegenüberliegenden Seite eine Klebeschicht auf, um das Dünnsteinerzeugnis auf einem Untergrund zu befestigen.

Auf der Steinschicht ist vorzugsweise keine Metallschicht angeordnet. Dies hat den Vorteil, dass das Dünnsteinerzeugnis dann nicht leitfähig ist und leichter elektrostatisch auf Oberflächen aufgebracht werden kann.

Vorzugsweise ist das Dünnsteinerzeugnis wechseltemperaturbeständig. Die Wechseltemperaturprüfung kann beispielsweise mit einem Temperaturzyklus von -20°C bis +80 °C gemäß DIN EN 12467 durchgeführt werden.

Vorzugsweise ist das Dünnsteinerzeugnis UV-lichtbeständig.

Vorzugsweise ist das Dünnsteinerzeugnis chemikalienbeständig. Die Chemikalienbeständigkeit kann gemäß DIN 68861 (EN 12720) 1B gemessen werden.

Vorzugsweise ist das Dünnsteinerzeugnis feuchtigkeitsundurchlässig. Die Feuchtigkeitsundurchlässigkeit kann gemäß DIN EN 12467 gemessen werden.

Vorzugsweise ist das Dünnsteinerzeugnis von -40 °C bis 160 °C temperaturbeständig. Die Temperaturbeständigkeit kann gemäß DIN EN 12467 gemessen werden.

Vorzugsweise ist das Dünnsteinerzeugnis frostbeständig. Die Frostbeständigkeit kann mit der Frost-Tauwechselprüfung gemäß DIN EN 12467 gemessen werden.

Vorzugsweise ist das Dünnsteinerzeugnis überlackierbar.

### Steinschicht

Gemäß der vorliegenden Erfindung ist die Steinschicht eine Schieferschicht. Die Schieferschicht besteht vorzugsweise nicht aus Parallelschiefer und besonders bevorzugt aus Druckschiefer bzw. Dachschiefer. Auch liegt der Winkel zwischen Schieferung und Schichtung in einem Bereich von 2 bis 90°, besonders bevorzugt in einem Bereich von 5 bis 30°. Vorzugsweise wird auch kein Glimmerschiefer oder Buntschiefer eingesetzt. Dadurch ist das Dünnsteinerzeugnis besonders frostsicher. Dachschiefer hat darüber hinaus den Vorteil, dass dieser eine wesentlich gleichmäßigere Schieferung hat und Fehlstellen im Endprodukt so besser vermieden werden können. Bei Druckschiefer oder Dachschiefer sorgen die vernetzen Glimmerlagen für eine bessere Witterungsbeständigkeit. Die Herausforderung bei der Erstellung von Furnieren aus Druckschiefern ist das Loslösen der vernetzten Glimmerlagen aus der Struktur des Schiefers. Durch das erfindungsgemäße Verfahren ist dies aber möglich.

Es liegt der Median der Schichtdicke der Steinschicht des Dünnsteinerzeugnisses in einem Bereich 0,6 bis 80 µm, bevorzugt in einem Bereich von 1 bis 70 µm. Vorzugsweise liegt die absolute Dicke der Schichtdicke der Steinschicht an jeder Stelle des Dünnsteinerzeugnisses in einem Bereich von 2 bis 300 µm. Der Median der Schichtdicke der Steinschicht kann beispielsweise über eine Messstrecke von 100 cm und 20 auf dieser Strecke gleichmäßig verteilten Messpunkten ermittelt werden. Die Steinschicht kann beispielsweise an einigen Stellen nur 10 µm und an anderen Stellen beispielsweise bis zu 450 µm dick sein.

Vorzugsweise liegt die Standardabweichung der Schichtdicke der Steinschicht in einem Bereich von 0,5 bis 70 µm.

Vorzugsweise erfüllt der Schiefer der Steinschicht die Anforderungen der Norm DIN EN12326.

Die Wasseraufnahme des Steins bzw. der Steinschicht liegt vorzugsweise bis zu 0,6 Gew.%. Dadurch hat das Dünnsteinerzeugnis eine besonders hohe Frost-Tau-Wechselbeständigkeit.

### Polymerschicht

Die Polymerschicht ist eine Klebeschicht.

Der Transmissionsgrad (Licht) der Polymerschicht liegt vorzugsweise in einem Bereich von 80 bis 100%.

Das Polymer ist vorzugsweise Aminoplast und/oder Silikon.

Dadurch wird eine besonders hohe Lichttransmission erreicht.

Die Polymerschicht kann eine einzelne Polymerschicht sein. Sie kann aber auch aus mehreren Teilschichten bestehen. Die Teilpolymerschichten können beispielsweise durch Grenzflächen abgetrennt sein. Diese Grenzflächen können dadurch entstehen, dass beispielsweise zunächst eine Teilpolymerschicht aufgetragen wird und dann zumindest teilweise ausgehärtet wird. Erst anschließend kann dann beispielsweise eine weitere Teilpolymerschicht aufgetragen werden, wodurch dann die Grenzfläche entsteht. Dies hat den Vorteil, dass ein etwaiges Fasergebilde beispielsweise auf eine erste zumindest teilweise ausgehärtete Teilpolymerschicht aufgelegt werden kann und dann erst eine weitere Teilpolymerschicht aufgetragen wird, womit verhindert werden kann, dass ein etwaiges Fasergebilde direkt mit der Steinschicht in Kontakt kommt.

Die Polymerschicht beziehungsweise das nicht ausgehärtete Polymerharz enthält vorzugsweise 50 bis 100 Gew.% Polyasparaginsäureester (auch Polyaspartics genannt), Polyharnstoff, Polyurethan, und/oder Mischungen derselben. Die Polymerschicht beziehungsweise das nicht ausgehärtete Polymerharz enthält vorzugsweise jedenfalls Polyasparaginsäureester und/oder Polyharnstoff. Dies schließt beispielsweise auch Hybridsysteme ein. Dies können Mischungen sein. Im Fall von Polyharnstoff kann eine Hybridvariante aus Monomeren wie Isocyanat und einer Polyol-Amin-Mischung entstehen bzw. im ausgehärteten Zustand die entsprechenden Einheiten enthalten. Im Falle des nicht ausgehärteten Polymerharzes kann es sich auch um die Vorstufen (z.B. die entsprechenden Monomere) handeln.

Polyasparaginsäureester sind sterisch gehinderte sekundäre Amine, die langsamer mit Isocyanaten reagieren als primäre Amine. Es wird angenommen, dass die kontrollierte Reaktivität von Polyasparaginsäureestern auf die sterisch gehinderte Umgebung der sekundären Amingruppen zurückzuführen ist, die sich in einer Beta-Position relativ zu einem Estercarbonyl befinden, sowie auf die potenzielle Wasserstoffbrückenbindung zwischen den sekundären Amingruppen und dem Estercarbonyl. Polyasparaginsäureester können durch die Michael-Additionsreaktion von Polyaminen mit Dialkylmaleat hergestellt werden. Wie Polyasparaginsäureester sind auch Polyetherasparaginsäureester sterisch gehinderte sekundäre Polyamine. Polyetherasparaginsäureester können durch die Michael-Additionsreaktion von Polyetheraminen mit Dialkylmaleat hergestellt werden.

Die vorliegenden Erfinder haben unerwartet entdeckt, dass die Zugabe von Polyetherasparaginsäureestern zu einer Bindemittelkomponente eines Zweikomponenten-Polyharnstoff-Beschichtungssystems (wobei die Bindemittelkomponente auch Polyasparaginsäureester enthält) die Aushärtungsgeschwindigkeit (gemessen als Durchtrocknungszeit der Stufe D gemäß ASTM D5895-03, Methode B) eines Beschichtungsfilms erhöht, der mit einer Isocyanat-Härterkomponente vernetzt wird, dass aber die Zugabe der Polyetherasparaginsäureester die Topfzeit der gemischten Beschichtungszusammensetzung (gemessen als zeitabhängige Viskosität) nicht verringert.

Wie hier verwendet, bezieht sich der Begriff "Topfzeit" auf den Zeitraum von der anfänglichen Mischung von zwei oder mehr miteinander reaktiven Komponenten eines Beschichtungssystems bis zu dem Punkt, an dem die resultierende Beschichtungszusammensetzung eine verarbeitbare Viskosität aufweist. Wie hierin verwendet, bezieht sich der Begriff "Aushärtungszeit" auf die Zeit bis zum Erreichen der Stufe D (Methode B) gemäß der Definition in ASTM D5895-03 (2008)-Standard Test Methods for Evaluating Drying or Curing During Film Formation of Organic Coatings Using Mechanical Recorder, die durch Bezugnahme in diese Spezifikation aufgenommen wird. Ebenso bezieht sich der Begriff "ausgehärtet" auf den Zustand einer flüssigen Beschichtungszusammensetzung, in dem ein aus der Beschichtungszusammensetzung gebildeter Film die Stufe D gemäß der Definition in ASTM D5895-03 (2008) erreicht. Wie hierin verwendet, beziehen sich die Begriffe "Aushärtung" auf die Entwicklung einer flüssigen Beschichtungszusammensetzung vom flüssigen Zustand zu einem ausgehärteten Zustand. Ein Trocknungszustand der Stufe D, wie in ASTM D 5895-03 definiert, ist gleichbedeutend mit einem "Durchtrocknungszustand".

Wie hier verwendet, bezieht sich der Begriff "Isocyanat" auf Verbindungen, die mindestens zwei nicht umgesetzte Isocyanatgruppen enthalten. Isocyanate können beispielsweise Diisocyanate und Diisocyanat-Reaktionsprodukte, die z. B. Biuret, Isocyanurat, Uretdion, Urethan, Harnstoff, Iminooxadiazindion, Oxadrazintrion, Carbodiimid, Acylharnstoff, Allophanatgruppen und Kombinationen davon umfassen. Wie hier verwendet, bezieht sich der Begriff "Amin" auf Verbindungen, die mindestens zwei freie primäre und/oder sekundäre Amingruppen umfassen. Polyamine schließen Polymere ein, die mindestens zwei anhängende und/oder endständige Amingruppen umfassen.

Nicht einschränkende Beispiele für geeignete Isocyanate können monomere und/oder polymere Isocyanate umfassen. Die Polyisocyanate können aus Monomeren, Präpolymeren, Oligomeren oder Mischungen davon ausgewählt werden. In einer Ausführungsform kann das Polyisocyanat ein lineares, verzweigtes, zyklisches, aromatisches C2-C20-Isocyanat oder ein Gemisch davon sein. Die Isocyanatkomponente kann jedes der bekannten Isocyanate der Polyurethanchemie umfassen. Beispiele für geeignete Isocyanate mit niedrigerem Molekulargewicht (z.B., mit einem Molekulargewicht von 168 bis 300 g/mol) umfassen, sind aber nicht beschränkt auf 1,4-Tetramethylendiisocyanat; Methylpentamethylendiisocyanat; 1,6-Hexamethylendiisocyanat (HDI); 2,2,4-Trimethyl-1,6-hexamethylendiisocyanat; 1,12-Dodecamethylendiisocyanat; Cyclohexan-1,3- und -1,4-diisocyanat; 1-Isocyanato-2-isocyanatomethylcyclopentan; 1-Isocyanato-3-isocyanatomethyl-3,5,5-trimethyl-cyclohexan (Isophorondiisocyanat oder IPDI); Bis-(4-isocyanato-cyclohexyl)-methan; 1,3- und 1,4-Bis-(isocyanatomethyl)-cyclohexan; Bis-(4-isocyanatocyclo-hexyl)-methan; 2,4'-Diisocyanato-dicyclohexylmethan; Bis-(4-isocyanato-3-methylcyclohexyl)-methan; α,α,α',α'-Tetramethyl-1,3- und/oder -1,4-Xylylendiisocyanat; 1-Isocyanato-1-methyl-4(3)-isocyanatomethyl, Cyclohexan; 2,4- und/oder 2,6-Hexahydro-Toluylendiisocyanat; 1,3- und/oder 1,4-Phenylendiisocyanat; 2,4- und/oder 2,6-Toluylendiisocyanat; 2,4- und/oder 4,4'-Diphenylmethandiisocyanat (MDI); 1,5-Diisocyanato-Naphthalin; und Kombinationen davon.

Beispiele für geeignete Polyasparaginsäureester umfassen die Polyasparaginsäureester, die in U.S. Patentnummern 5,126,170; 5,236,741; 5,489,704; 5,243,012; 5,736,604; 6,458,293; 6,833,424; 7,169,876; und in der US-Patentveröffentlichung Nr. 2006/0247371, beschrieben sind, die durch Bezugnahme in diese Beschreibung aufgenommen sind. Darüber hinaus sind geeignete Polyasparaginsäureester kommerziell beispielsweise von Bayer MaterialScience unter den Handelsnamen Desmophen NH 1220, Desmophen NH 1420, Desmophen NH 1520 und Desmophen NH 1521 erhältlich.

Der Polyharnstoff wird beispielsweise aus einer Reaktionsmischung gebildet, die Isocyanat und Amin enthält, wobei das Verhältnis der Äquivalente der Isocyanatgruppen zu den Äquivalenten der Amingruppen größer als 1 ist.

Geeignete Amine zur Verwendung in der vorliegenden Erfindung können aus einer Vielzahl von bekannten Aminen, wie z. B. primären und sekundären Aminen, und Mischungen davon ausgewählt werden. In alternativen Ausführungsformen kann das Amin Monoamine oder Polyamine mit mindestens zwei funktionellen Gruppen, wie Di-, Tri- oder höher funktionelle Amine, und Mischungen davon umfassen. In weiteren Ausführungsformen kann das Amin aromatisch oder aliphatisch sein, wie z. B. cycloaliphatisch, oder Mischungen davon. Nicht einschränkende Beispiele geeigneter Amine können aliphatische Polyamine umfassen, wie z. B., aber nicht beschränkt auf Ethylamin, isomere Propylamine, Butylamine, Pentylamine, Hexylamine, Cyclohexylamin, Ethylendiamin, 1,2-Diaminopropan, 1,4-Diaminobutan, 1,3-Diaminopentan, 1,6-Diaminohexan, 2-Methyl-1,5-pentandiamin, 2,5-Diamino-2,5-dimethylhexan, 2,2,4- und/oder 2,4,4-Trimethyl-1,6-diaminohexan, 1,11-Diaminoundecan, 1,12-Diaminododecan, 1, 3- und/oder 1,4-Cyclohexandiamin, 1-Amino-3,3,5-trimethyl-5-aminomethyl-cyclohexan, 2,4- und/oder 2,6-Hexahydrotoluoylendiamin, 2,4'- und/oder 4,4'-Diamino-dicyclohexylmethan und 3,3'-Dialkyl-4,4'-diamino-dicyclohexylmethane (wie 3, 3'-Dimethyl-4,4'-diamino-dicyclohexylmethan und 3,3'-Diethyl-4,4'-diamino-dicyclohexylmethan), 2,4- und/oder 2,6-Diaminotoluol und 2,4'- und/oder 4,4'-Diaminodiphenylmethan, oder Mischungen davon.

Die Polymerschicht beziehungsweise das nicht ausgehärtete Polymerharz enthält vorzugsweise keinen Polyester. Polyester kann umweltschädlich sein und hat oft das Problem, dass unangenehm riechende Gase austreten.

Vorzugsweise liegt der Gehalt an Methacrylaten, Acrylaten, Polyestern, und/oder Polyethern und insbesondere ausgehärtetem Epoxidharz in einem Bereich von 0 bis 1 Gew.%. Besonders bevorzugt enthält die Polymerschicht keine Polyether. Vorzugsweise liegt der Gehalt an Styrol in einem Bereich von 0 bis 1 Gew.%. Besonders bevorzugt enthält die Polymerschicht kein Styrol. Vorzugsweise liegt der Gehalt an Lösungsmittel in einem Bereich von 0 bis 1 Gew.%. Besonders bevorzugt enthält die Polymerschicht kein Lösungsmittel. Vorzugsweise liegt der Gehalt an Wasser in einem Bereich von 0 bis 1 Gew.%. Besonders bevorzugt enthält die Polymerschicht kein Wasser. Die Teilpolymerschichten können aus unterschiedlichen Materialien bestehen. Vorzugsweise bestehen sie jedoch aus demselben Material.

Der Gehalt an Polyurethan kann in einem Bereich von 0 bis 80 Gew.% liegen. Alternativ bevorzugt kann der Gehalt von Polyurethan auch in einem Bereich von 0 bis 100 Gew.% liegen.

Besonders bevorzugt wird die Polymerschicht aus einem 2-Komponenten-Polyurethanklebstoff erhalten.

Vorzugsweise weist die Polymerschicht eine Dicke in einem Bereich von 0,08 bis 3 mm, besonders bevorzugt in einem Bereich von 0,4 bis 1 mm auf.

Die Polymerschicht kann wie oben dargestellt aus Teilpolymerschichten bestehen. Diese Teilpolymerschichten weisen vorzugsweise jeweils eine Dicke in einem Bereich von 0,08 bis 1 mm, besonders bevorzugt in einem Bereich von 0,15 bis 0,4 mm auf. Die erste an die Steinschicht angrenzende Teilpolymerschicht kann dicker als die übrigen Teilpolymerschichten sein. Alternativ kann die erste an die Steinschicht angrenzende Teilpolymerschicht auch dünner als die übrigen Teilpolymerschichten sein, wenn beispielsweise eine erste Teilpolymerschicht als Primer aufgetragen wird.

Die Dichte der Polymerschicht liegt vorzugsweise in einem Bereich von 0,6 bis 1,2 g/cm3 und kann beispielsweise nach DIN 53479 gemessen werden.

Die Shore D Härte der Polymerschicht liegt vorzugsweise in einem Bereich von 60 bis 100 und kann beispielsweise nach DIN 53505 gemessen werden.

Die Viskosität des unausgehärteten Harzes für die Polymerschicht liegt vorzugsweise in einem Bereich von 0,5 bis 2000 mPa·s. Dies hat den Vorteil, dass das Harz dann mittels Sprühauftrag aufgetragen werden kann.

Vorzugsweise enthält das unausgehärtete Harz zum Erhalt der Polymerschicht einen Katalysator beispielsweise zur Einstellung der Aushärtezeit. Der Katalysator wird vorzugsweise einer Polyolkomponente zugesetzt. Dadurch kann die Aushärtezeit besonders leicht eingestellt werden.

Die Polymerschicht beziehungsweise das nicht ausgehärtete Polymerharz enthält beispielsweise auch Zuschlagstoffe wie Füllstoffe und/oder Brandschutzmittel. Die Zuschlagstoffe können insgesamt in einem Bereich von 1 bis 75 Gew.% enthalten sein. Die Brandschutzmittel können anorganisch sein (beispielsweise Perlit). Die Brandschutzmittel. können in einem Bereich von 20 bis 75 Gew.%, besonders bevorzugt 40 bis 70 Gew.%, enthalten sein. Die Brandschutzmittel können fest oder flüssig sein. Dies hat den Vorteil, dass das Dünnsteinerzeugnis dann beispielsweise auch für die Verkleidung von Fassaden eingesetzt werden kann.

### Fasern

Die Polymerschicht kann Fasern enthalten. Die Fasern können lose Fasern sein oder als Fasergebilde vorliegen. Die losen Fasern können Endlosfasern oder auch Faserabschnitte sein. Die Faserabschnitte können eine durchschnittliche Länge im Median im Bereich von 0,1bis 10 cm aufweisen. Die Fasern können in der Polymerschicht in einem Bereich von 0,05 bis 20 Gew.% enthalten sein. Das Material der Fasern kann ausgewählt sein aus der Gruppe Glasfasern. Der Faserdurchmesser kann im Median vorzugsweise in einem Bereich von 0,1 bis 50 µm liegen.

Das Fasergebilde kann auch ein Gewebe und/oder eine Matte sein. Dadurch kann es eine gute und gleichmäßige Durchdringung mit dem Harz und einen definierten Harzauftrag geben. Daher ist das Fasergebilde vorzugsweise auch kein Wirrvlies oder Wirrfasergelege.

Alternativ kann die Polymerschicht auch keine Fasern enthalten.

Die Fasern bestehen vorzugsweise aus anorganischem Material und ganz besonders bevorzugt aus Glas. Dadurch können besonders gute mechanische Kennwerte des erfindungsgemäßen Erzeugnisses und eine besonders gute Brandfestigkeit erreicht werden. Alternativ können die Fasern auch aus organischem Material wie beispielsweise Zellulose oder Baumwolle bestehen.

Der Abstand zwischen dem Fasergebilde und der Steinschicht liegt vorzugsweise in einem Bereich von 0,05 bis 0,7 mm. Das Fasergebilde berührt die Steinschicht vorzugsweise nicht. Dadurch kann besonders leicht vermieden werden, dass das Gewebe durch die dünne Steinschicht sichtbar ist.

Vorzugsweise ist das Fasergebilde hinter der Rückseite der Steinschicht angeordnet. Besonders bevorzugt ist das Fasergebilde nämlich in der Polymerschicht eingebettet.

### Weitere Ausführungsformen

In einer weiteren Ausführungsform wird die der Erfindung zu Grunde liegende Aufgabe durch ein Verfahren zur Herstellung eines erfindungsgemäßen Moduls einer Solaranlage gemäß Anspruch 6 gelöst, bei dem wenigstens folgende Schritte ausgeführt werden:
a) Auftragen eines noch nicht ausgehärteten Polymerharzes auf die Steinoberfläche,
b) Aushärten des Polymerharzes,
c) Abziehen des ausgehärteten Polymerharzes von der Steinoberfläche, wobei eine mit dem ausgehärteten Polymerharz verklebte Steinschicht von der Steinoberfläche mit abgezogen wird und so das Dünnsteinerzeugnis entsteht,
d) Verkleben des Dünnsteinerzeugnisses mit einem Modul einer Solaranlage, wobei das Dünnsteinerzeugnis auf der der Steinschicht gegenüberliegenden Seite eine Klebeschicht aufweist.

Der Stein ist gemäß der vorliegenden Erfindung Schiefer. Vorzugsweise handelt es sich daher bei dem Dünnsteinerzeugnis um ein Dünnsteinerzeugnis, der Steinoberfläche um eine Schieferoberfläche und bei der Steinschicht um eine Steinschicht.

Oft ist es so, dass die Steinoberfläche gerade beispielsweise bei Schiefer eine Rautiefe von > 2000 µm oder auch < 2 µm (bei geschliffenem Schiefer) aufweist. Um die eingangs erwähnten Fehler in der Produktion zu minimieren, muss vor dem Auftrag des Polymerharzes sichergestellt werden, dass die Rautiefe in dem erfindungsgemäße Bereich liegt.

Um die bevorzugte Rautiefe sicherzustellen, kann es vorteilhaft sein, dass die Steinoberfläche zunächst soweit abgetragen (z.B. abgeschliffen) wird, dass die bevorzugte Rautiefe erreicht ist.

Das Polymerharz kann die oben beschriebenen Fasern enthalten.

Vorzugsweise ein Schritt wie das erneute Auftragen eines noch nicht ausgehärteten Polymerharzes nach Schritt a) durchgeführt werden. Dieser Schritt kann beispielsweise auch nach dem Auflegen eines Fasergebildes auf das aufgetragene Polymerharz durchgeführt werden.

Schritt c) wird vorzugsweise über eine Trommel oder Walze durchgeführt. Dafür wird das ausgehärtete Polymerharz mit dem Fasergebilde vorzugsweise über die gesamte Breite an einer der vier Kanten in einer Haltevorrichtung der Walze oder Trommel befestigt und dann durch Abrollen der Walze oder Trommel abgezogen. Die Haltevorrichtung kann beispielsweise ein Klemmspalt sein.

Vorzugsweise wird vor Schritt c) und besonders bevorzugt vor Schritt b) ein Greifstreifen (oder auch Abzugshilfe) an einer Kante eingebracht. Der Greifstreifen dient dann dazu, dass die Haltevorrichtung diesen Greifstreifen nach der Aushärtung greifen kann und dann das Dünnsteinerzeugnis von der Steinoberfläche abziehen kann. Beispielsweise kann ein Greifstreifen aus dem mit Polymerharz bedeckten Bereich herausstehen. Insbesondere ist der Greifstreifen über wenigstens 80% der Länge einer Kante vorgesehen. Der Greifstreifen kann 1 bis 20 cm breit sein. Der Greifstreifen kann aus einem Gewebe bestehen.

Schritt c) findet vorzugsweise bei einer Temperatur der Polymerschicht in einem Bereich von 5 bis 35 °C statt. Es kann also beispielsweise nötig sein, die Polymerschicht zunächst vor dem Abziehen abzukühlen. Dies kann beispielsweise mit kalter Luft geschehen. Wenn die Temperatur oberhalb dieses Bereiches liegt, kann es zu Delamination der Schichten bzw. Teilschichten kommen.

In Schritt c) wird die Steinschicht vorzugsweise mechanisch und besonders bevorzugt nicht chemisch von der Steinoberfläche gelöst. Dies ist beispielsweise dadurch möglich, dass ein Polymer eingesetzt wird, das sich in der Oberflächenstruktur des Steins verkrallen kann.

In den Schritten a) oder dem erneuten Auftrag wird das nicht ausgehärtete Polymerharz vorzugsweise mit einer Temperatur oberhalb der Raumtemperatur, besonders bevorzugt in einem Bereich von 40 bis 100 °C, eingesetzt. Die Viskosität des Polymerharzes wird durch den Wärmeeintrag stark herabgesetzt wodurch sich die Verarbeitungseigenschaften ändern. Das Fasergebilde wird deutlich besser getränkt und eingearbeitete Luftblasen können leichter entweichen.

Die Menge an aufgetragenem Harz in den Schritten a) oder dem erneuten Auftrag weicht vorzugsweise voneinander 0 bis 100% ab. Es wird also vorzugsweise in einem der Auftragsschritte maximal doppelt so viel Harz wie in dem anderen Auftragsschritt aufgetragen.

Gemäß der vorliegenden Erfindung ist die Steinoberfläche eine Schieferplatte. Besonders bevorzugt wird die Steinplatte zumindest auf deren Oberfläche vor Durchführung des Schrittes a) auf eine Temperatur oberhalb der Raumtemperatur, besonders bevorzugt in einem Bereich von 40 bis 100 °C, erwärmt. Vorzugsweise wird zum Rand der Steinoberfläche ein Rand, eine Breite in einem Bereich von 1 bis 15 cm gelassen. Die Steinplatte hat vorzugsweise eine Dicke in einem Bereich von 1 bis 20 cm.

Vorzugsweise wird das Polymerharz in Schritt a) und/oder bei dem erneuten Auftrag mittels Sprühen und ganz besonders bevorzugt durch luftloses Sprühen aufgetragen. Sprühen hat den Vorteil, dass ein besonders gleichmäßiger Auftrag möglich ist. Luftloses Sprühen hat den Vorteil, dass weniger Gasblasen in die aufgetragene Schicht eingelagert werden.

Vorzugsweise wird das Polymerharz u.a. aus Polyol und Isocyanat gebildet. Diese Komponenten werden vorzugsweise erst unmittelbar vor dem Auftrag gemischt. Beispielsweise befindet sich ein Mischkopf unmittelbar vor der Düse oder die Düse ist in den Mischkopf integriert.

Zwischen Schritt a) und b) wird vorzugsweise solange gewartet, bis das Harz angeliert ist, besonders bevorzugt ein Vernetzungsgrad von wenigstens 0,1% erreicht ist.

Zwischen den Schritten a) und c) liegt vorzugsweise ein Zeitraum von 0 bis 24h, bevorzugt ein Zeitraum von 0,1 bis 60 Minuten. In den bisher bekannten vergleichbaren Verfahren wurde üblicherweise ein Tag gewartet, bevor die Steinschicht abgezogen wurde.

Schritt b) wird vorzugsweise bei Raumtemperatur durchgeführt. Der Schritt b) kann aber auch zumindest teilweise in einem Ofen durchgeführt werden. Hierbei wird die Temperatur des Ofens beispielsweise auf eine Temperatur in einem Bereich von 60 bis 160 °C eingestellt.

Nach Schritt b) wird die mit Polymer beschichtete Steinplatte beispielsweise getempert. Diese Temperung kann in einem Ofen stattfinden. Im Ofen kann dafür eine Temperatur in einem Bereich von 60 bis 160 °C eingestellt sein. Die Temperung kann über einen Zeitraum von 5 bis 500 Minuten durchgeführt werden. Vorzugsweise wird in Schritt b) eine spaltraue Schieferoberfläche eingesetzt. Ganz besonders bevorzugt ist die Schieferoberfläche nicht geschliffen.

Vorzugsweise wird das Verfahren kontinuierlich durchgeführt.

Um die Gesamtdicke des erfindungsgemäßen Dünnsteinerzeugnisses zu verringern, kann das ausgehärtete Polymerharz anschließend an die Aushärtung abgeschliffen werden. Beispielsweise kann die Dicke der Polymerschicht durch das Abschleifen um eine Dicke in einem Bereich von 10 bis 200 µm reduziert werden. Die Dicke der Polymerschicht kann beispielsweise auf eine Dicke von bis zu 200 µm, besonders bevorzugt bis zu 50 µm, reduziert werden.

In einer weiteren Ausführungsform wird die der Erfindung zu Grunde liegende Aufgabe durch die Verwendung des Moduls einer Solaranlage gemäß Anspruch 7 gelöst. Das erfindungsgemäße Modul einer Solaranlage wird für Fahrzeuginnenverkleidung, Dachbelag, Fassadenverkleidung, Wohnraumverkleidung, dekorative Gebrauchs- Gestaltungsgegenstände, und/oder als Kunststoff/Holzfurnierersatz verwendet.

Insbesondere als Dachbelag hat das erfindungsgemäße Modul einer Solaranlage einen Vorteil, da die Dicke typischer photovoltaischer Zellen in einem Bereich von 5 - 7 mm liegt und übliche Dachschieferplatten eine Dicke in einem Bereich von 5 bis 8 mm aufweisen. Die erfindungsgemäßen photovoltaischen Zellen können daher bisherige Dachschieferplatten ersetzen.

### Ausführungsbeispiel

Als Harz für die Polymerschicht wurde ein kommerziell erhältliches Polymersystem (teknopur sk 10, ein experimentelles Produkt der Firma teknos Finnland) eingesetzt. Als Härter wurde teknopur 500-800 derselben Firma eingesetzt. Dieses Polymersystem zeichnet sich dadurch aus, dass es eine gute Verklebung mit Naturstein ermöglicht und optisch transparent und klar ist. Eine Schieferplatte mit den Abmaßen 125 cm x 60 cm und einer Rautiefe von 1 mm wurde mit dem Harz beschichtet und erfuhr nach dem Auftrag Strahlungswärme von 40° C in ca. 70 cm Entfernung über der Platte befindlichen Heizstrahlern. Vor dem Beschichten wurde auf eine Kante über die gesamte Breite der Kante ein 5 cm breiter Glasgewebestreifen so aufgelegt, dass er zur Hälfte mit beschichtet wurde und die andere Hälfte aus der Beschichtung herausstand Die Oberflächentemperatur der Schieferplatte wurde maximal auf 80 bis 100°C eingestellt. Es wurde abgewartet bis die Polymerschicht klopffest ausgehärtet war. Danach erfolgte der Abzug des Furniers von der Schieferplatte. Der Abzug des Furniers wurde bei einer Oberflächentemperatur von < 35°C durchgeführt, indem die gesamte Oberkante des Schichtverbundes der Polymerschicht mit Hilfe des Glasfasergewebestreifens in einem Klemmspalt einer Walze festgeklemmt wurde und dann die Walze durch Abrollen langsam und vorsichtig das fertige Dünnsteinerzeugnis mit einer abgezogenen Steinschicht erzeugte.

Der zeitliche Ablauf war wie folgt:
- Auftrag des Harzes
- Aushärtung bei etwa 40 °C Temperatur für etwa 10 Minuten
- Tempern bei etwa 80°C Oberflächentemperatur für etwa 30 Minuten
- einige Stunden ruhen lassen
- Abziehen

Es entstand das Dünnsteinerzeugnis.

Ein handelsübliches Photovoltaikmodul (Heckert Solar Module, 1767 × 1041 × 35 mm) wurde mit dem vorgenannten Polymer beschichtet und anschließend mit dem Dünnsteinerzeugnis belegt. Das Polyharnstoffsystem wurde ausgehärtet, so dass das Dünnsteinerzeugnis mit dem Photovoltaikmodul verklebt war. Es wurde 10 Prüfmuster hergestellt.

Um die Leistung zu beurteilen, wurde zunächst ein unbeschichtetes Photovoltaikmodul mit einer konstanten Lichtquelle bestrahlt. Die erzeugte Leerlaufspannung wurde vermessen.

Anschließend wurden die mit dem Dünnsteinerzeugnis verklebten Photovoltaikmodule mit derselben Lichtquelle mit derselben Lichtintensität bestrahlt. Die erzeugte Leerlaufspannung wurde vermessen.

Je nach verwendetem Stein, wurde für jede Probe der Prozentsatz der erreichten Leerlaufspannung im Vergleich zu dem unbeschichteten Photovoltaikmodul ermittelt:
Dünnsteinerzeugnis mit Schiefer: 88 %, 89,3 %, 87 %, 89,4 %,
Dünnsteinerzeugnis mit Quarzit: 87,5%, 94,8 %, 80 %, 93 %, 95 %, 90 %.

Die in der vorliegenden Beschreibung sowie in den Ansprüchen offenbarten Merkmale der Erfindung können sowohl einzeln als auch in beliebigen Kombinationen für die Verwirklichung der Erfindung in ihren verschiedenen Ausführungsformen wesentlich sein. Die Erfindung ist nicht auf die beschriebenen Ausführungsformen beschränkt. Sie kann im Rahmen der Ansprüche und unter Berücksichtigung der Kenntnisse des zuständigen Fachmanns variiert werden.

## Patentansprüche

1. Modul einer Solaranlage, das mit einem lichtdurchlässigen Dünnsteinerzeugnis verklebt ist, wobei das Dünnsteinerzeugnis eine außenliegende Steinschicht, die eine Dicke im Median in einem Bereich von 0,6 bis 80 µm aufweist, und eine daran angrenzende Polymerschicht aufweist, wobei die Steinschicht eine Schieferschicht ist und der Winkel zwischen Schieferung und Schichtung in einem Bereich von 2 bis 90° liegt, wobei die Rauheit Ra der Oberfläche der Rückseite des Dünnsteinerzeugnisses in einem Bereich von 2 bis 100 µm gemessen nach DIN EN ISO 25178 liegt, wobei die Rückseite des Dünnsteinerzeugnisses die angrenzende Polymerschicht aufweist, und wobei das Dünnsteinerzeugnis auf der der Steinschicht gegenüberliegenden Seite eine Klebeschicht zum Verkleben mit dem Modul einer Solaranlage aufweist.

2. Modul einer Solaranlage gemäß einem der vorhergehenden Ansprüche, **dadurch gekennzeichnet, dass** die Polymerschicht Polyasparaginsäureester und/oder Polyharnstoff enthält.

3. Modul einer Solaranlage gemäß einem der vorhergehenden Ansprüche, **dadurch gekennzeichnet, dass** die Standardabweichung der Schichtdicke der Steinschicht in einem Bereich von 0,5 bis 70 µm liegt.

4. Modul einer Solaranlage gemäß einem der vorhergehenden Ansprüche, **dadurch gekennzeichnet, dass** die Steinschicht eine Schieferschicht ist und der Winkel zwischen Schieferung und Schichtung in einem Bereich von 5 bis 30° liegt.

5. Modul einer Solaranlage gemäß einem der vorhergehenden Ansprüche, **dadurch gekennzeichnet, dass** das Dünnsteinerzeugnis im Median eine Dicke in einem Bereich von 0,08 bis 3 mm aufweist.

6. Verfahren zur Herstellung eines Moduls einer Solaranlage gemäß einem der Ansprüche 1 bis 5, bei dem wenigstens folgende Schritte ausgeführt werden:
a. Auftragen eines noch nicht ausgehärteten Polymerharzes auf die Steinoberfläche,
b. Aushärten des Polymerharzes,
c. Abziehen des ausgehärteten Polymerharzes von der Steinoberfläche, wobei eine mit dem ausgehärteten Polymerharz verklebte Steinschicht von der Steinoberfläche mit abgezogen wird und so das Dünnsteinerzeugnis entsteht,
d. Verkleben des Dünnsteinerzeugnisses mit einem Modul einer Solaranlage, wobei das Dünnsteinerzeugnis auf der der Steinschicht gegenüberliegenden Seite eine Klebeschicht aufweist.

7. Verwendung des Moduls einer Solaranlage gemäß einem der Ansprüche 1 bis 5, für Fahrzeuginnenverkleidung, Dachverkleidung, Fassadenverkleidung, Wohnraumverkleidung, dekorative Gebrauchs-Gestaltungsgegenstände, und/oder als Kunststoff- oder Holzfurnierersatz.

## Claims

1. A solar system module bonded to a translucent thin stone product wherein the thin stone product comprises an external stone layer having a median thickness in a range from 0.6 to 80 µm and an adjacent polymer layer, wherein the stone layer is a slate layer and the angle between the bedding and the cleavage is in a range from 2 to 90 degrees, wherein the roughness Ra of the thin stone product back surface is in an range from 2 to 100 µm when measured according to DIN EN ISO 25178, wherein the thin stone product back comprising the adjacent polymer layer, and wherein the thin stone product comprises an adhesive layer for bonding with the solar system module on the side opposing the stone layer.

2. The solar system module according to any one of the preceding claims, **characterised in that** the polymer layer comprises polyaspartic esters and/or polyurea.

3. The solar system module according to any one of the preceding claims, **characterised in that** the standard deviation of the layer thickness of the stone layer is in a range from 0.5 to 70 µm.

4. The solar system module according to any one of the preceding claims, **characterised in that** the stone layer is a shale layer and the angle between the bedding and the cleavage is in a range from 5 to 30 degrees.

5. The solar system module according to any one of the preceding claims, **characterised in that** the median thickness of the thin stone product is in a range from 0.08 to 3 mm.

6. A process for manufacturing a solar system module according to any one of claims 1 to 5, wherein at least the following steps are performed:
a. applying a not yet cured polymer resin to the stone surface,
b. curing the polymer resin,
c. peeling the cured polymer resin from the stone surface, wherein a stone layer adhesively bonded to the cured polymer resin is also peeled from the stone surface, thus forming the thin stone product,
d. bonding the thin stone product to a solar system module, wherein the thin stone product comprises an adhesive layer on the side opposing the stone layer.

7. Use of the solar system module according to any one of claims 1 to 5 for a vehicle interior lining, roof lining, facade cladding, interior wall cladding, decorative designed articles of daily use and/or as plastic or wood veneer replacement.

## Revendications

1. Module d'un système solaire thermique qui est collé par un produit en pierre mince transparent à la lumière, dans lequel le produit en pierre mince comprend une couche de pierre externe qui présente une épaisseur médiane comprise dans une plage de 0,6 à 80 µm et comprend une couche de polymère adjacente à celle-ci, dans lequel la couche de pierre est une couche de schiste et l'angle entre la schistosité et la stratification se situe dans une plage de 2 à 90°, dans lequel la rugosité Ra de la surface de l'envers du produit en pierre mince se situe dans une plage de 2 à 100 µm mesurée selon DIN EN ISO 25178, dans lequel l'envers du produit en pierre mince comprend la couche de polymère adjacente, et dans lequel le produit en pierre mince comprend une couche adhésive sur le côté opposé de la couche de pierre pour le collage au module d'un système solaire thermique.

2. Module d'un système solaire thermique selon l'une des revendications précédentes, **caractérisé en ce que** la couche de polymère contient de l'ester d'acide polyaspartique et/ou de la polyurée.

3. Module d'un système solaire thermique selon l'une des revendications précédentes, **caractérisé en ce que** l'écart type de l'épaisseur de la couche de pierre se situe dans une plage de 0,5 à 70 µm.

4. Module d'un système solaire thermique selon l'une des revendications précédentes, **caractérisé en ce que** la couche de pierre est une couche de schiste et l'angle entre la schistosité et la stratification se situe dans une plage de 5 à 30°.

5. Module d'un système solaire thermique selon l'une des revendications précédentes, **caractérisé en ce que** le produit en pierre mince présente une épaisseur médiane comprise dans la plage de 0,08 à 3 mm.

6. Procédé de réalisation d'un module d'un système solaire thermique selon l'une des revendications 1 à 5, dans lequel au moins les étapes suivantes sont effectuées :
a. appliquer une résine polymère pas encore durcie sur la surface de la pierre,
b. durcir la résine polymère,
c. retirer la résine polymère durcie de la surface de la pierre, une couche de pierre liée à la résine polymère durcie étant également retirée de la surface de la pierre en créant ainsi le produit en pierre mince,
d. coller le produit en pierre mince à un module d'un système solaire thermique, dans lequel le produit en pierre mince comprend une couche adhésive sur le côté opposé à la couche de pierre.

7. Utilisation du module d'un système solaire thermique selon l'une des revendications 1 à 5 pour un revêtement intérieur d'un véhicule, un revêtement de toit, un revêtement de façade, un revêtement d'une pièce d'habitation, des objets décoratifs de conception utilitaire/structurelle et/ou comme remplacement de placage en plastique ou en bois.
